# EUROPÄISCHE PATENTSCHRIFT

(11) **EP 2 823 276 B1**
(45) Veröffentlichungstag und Bekanntmachung des Hinweises auf die Patenterteilung: **02.05.2018**
(21) Anmeldenummer: 13710814.8
(22) Anmeldetag: 08.03.2013
(51) Int. Cl.: B23K 1/00, G01P 1/02, G01D 11/24, G01L 19/14, B81B 7/00

(54) **MIKROMECHANISCHES MESSELEMENT UND VERFAHREN ZUR HERSTELLUNG EINES MIKROMECHANISCHEN MESSELEMENTS**
MICROMECHANICAL MEASURING ELEMENT, AND METHOD FOR PRODUCING A MICROMECHANICAL MEASURING ELEMENT
ÉLÉMENT DE MESURE MICROMÉCANIQUE ET PROCÉDÉ DE PRODUCTION D'UN ÉLÉMENT DE MESURE MICROMÉCANIQUE

(30) Priorität: 09.03.2012 DE 102012102021
(43) Veröffentlichungstag der Anmeldung: 14.01.2015
(60) Teilanmeldung: 18151268.2
(73) Patentinhaber: Epcos AG, 81671 München (DE)
(72) Erfinder: SCHIFFER, Michael, 10435 Berlin (DE); PESCHKA, Andreas, 14552 Michendorf (DE); ZAPF, Jörg, 81927 München (DE); WEIDNER, Karl, 81245 München (DE); HEDLER, Harry, 82110 Germering (DE)
(74) Vertreter: Epping - Hermann - Fischer
(86) Internationale Anmeldenummer: PCT/EP2013/054725
(87) Internationale Veröffentlichungsnummer: WO 2013/132065

(56) Entgegenhaltungen:
- WO-A2-03/067657
- DE-A1- 19 826 426
- DE-A1-102010 012 042
- US-A- 5 611 884
- US-A1- 2007 069 000

## Beschreibung

Es wird ein mikromechanisches Messelement angegeben. Weiterhin wird ein Verfahren zur Herstellung eines mikromechanischen Messelements angegeben.
Es sind zumindest firmenintern mikromechanische Messelemente bekannt, die beispielsweise als Drucksensoren, wie zum Beispiel Absolutdrucksensoren oder Relativ- beziehungsweise Differenzdrucksensoren, ausgebildet sind. Diese Drucksensoren weisen ein sensitives Element auf, das mittels eines Fügemediums, beispielsweise mittels eines Klebstoffs oder einer Lotverbindung, auf einer Chipaufnahme aufgebracht ist. Das sensitive Element kann beispielsweise Piezowiderstände aufweisen, deren elektrische Ausgangssignale mittels Drahtbondung zu Außenkontakten des Drucksensors geführt werden. Je nach Anwendung kann der Drucksensor einen Gehäusedeckel, der mit einer Medienzuführung versehen ist, aufweisen. Bei bekannten Drucksensoren werden die Medienzuführung, beispielsweise durch Montage des sensitiven Elements, und die elektrische Kontaktierung des Drucksensors, beispielsweise mittels Drahtbondung, in separaten Prozessschritten durchgeführt. Entsprechende Mikrimechanische Messelemente werden in den Dokumenten WO 03/067657 und US 5 611 884 offenbart. Es ist eine zu lösende Aufgabe zumindest einiger Ausführungsformen ein mikromechanisches Messelement anzugeben, das einfach herstellbar ist. Eine weitere Aufgabe zumindest einiger Ausführungsformen ist es, ein Verfahren zur Herstellung eines mikromechanischen Messelements anzugeben.

Diese Aufgaben werden durch einen Gegenstand und ein Verfahren gemäß den unabhängigen Patentansprüchen gelöst. Vorteilhafte Weiterbildungen sind in den abhängigen Patentansprüchen angegeben.

Ein mikromechanisches Messelement gemäß zumindest einer Ausführungsform weist ein sensitives Element und einen Träger auf. Der Träger kann beispielsweise ein Keramikmaterial aufweisen oder als Keramikplatte ausgeführt sein. Weiterhin ist es möglich, dass der Träger als Leiterplatte, beispielsweise als FR4-Leiterplatte ausgeführt ist. Das sensitive Element weist vorzugsweise Silizium auf oder besteht daraus. Beispielsweise kann das sensitive Element als Siliziumchip ausgeführt sein. Vorzugsweise ist das sensitive Element mittels zumindest einer ersten und zumindest einer zweiten Lotverbindung mit dem Träger verbunden. Beispielsweise kann das sensitive Element mittels der zumindest einen ersten und der zumindest einen zweiten Lotverbindung unmittelbar mit dem Träger verbunden sein. Das sensitive Element wird vorzugsweise über die erste Lotverbindung elektrisch kontaktiert.

Gemäß einer Weiterbildung bilden das sensitive Element, der Träger und die zweite Lotverbindung eine erste Kammer. Die erste Kammer weist vorzugsweise eine erste Öffnung auf. Weiterhin ist es möglich, dass die erste Kammer durch das sensitive Element, den Träger, die zweite Lotverbindung und weitere Komponenten gebildet ist. Die weiteren Komponenten können beispielsweise Elastomerkörper und/oder Metallisierungen sein, die zwischen dem sensitiven Element und der zweiten Lotverbindung und/oder zwischen der zweiten Lotverbindung und dem Träger angeordnet sind.

Gemäß einer Weiterbildung ist die erste Öffnung der ersten Kammer derart ausgebildet, dass ein erstes Medium der ersten Kammer zuführbar ist. Vorzugsweise weist das sensitive Element eine Membran mit einer Unterseite und mit einer Oberseite auf. Das sensitive Element kann beispielsweise ein aus einem Siliziumwafer hergestellter Siliziumchip mit einer Membran sein, wobei die Membran einen abgedünnten Bereich, zum Beispiel einen dünngeätzten Bereich des Siliziumchips, bildet. Die Oberseite der Membran kann dem ersten Medium, das im hier und im Folgenden auch als Messmedium oder als Übertragungsmedium bezeichnet werden kann, mittels der ersten Öffnung zugänglich sein. Das Messmedium kann einen beaufschlagten Druck auf die Membran des sensitiven Elements übertragen, wodurch eine Druckbestimmung ermöglicht werden kann. Beispielsweise ist das sensitive Element als piezoresistives Element ausgeführt, das Piezowiderstandsstrukturen, Zuleitungen und Kontaktierflächen aufweist. Über eine druckabhängige Verformung der Membran und der darin implantierten Piezowiderstandsstrukturen, die beispielsweise zu einer Wheatstonebrücke verschaltet sind, kann es infolge der Widerstandsänderung der Piezowiderstandsstrukturen zur Änderung der elektrischen Ausgangsspannung der Wheatstonebrücke kommen, mittels derer sich der beaufschlagte Druck oder eine Druckänderung bestimmen lässt. Alternativ kann das sensitive Element auch als kapazitives oder piezoelektrisches Element ausgeführt sein.

Bei der Herstellung eines hier beschriebenen mikromechanischen Messelements können vorteilhafterweise elektrische und fluidische Anschlüsse in einem simultanen Prozessschritt realisiert werden. Weiterhin kann gewährleistet werden, dass die fluidischen Anschlüsse von den elektrischen Anschlüssen getrennt sind.

Gemäß einer Weiterbildung ist das sensitive Element auf einem Substrat angeordnet. Das Substrat kann beispielsweise Glas und/oder Silizium aufweisen oder aus einem dieser Materialien bestehen.

Gemäß einer Weiterbildung weist das mikromechanische Messelement eine Kappe auf, die unmittelbar mit dem Träger verbunden ist. Vorzugsweise umgibt die Kappe zumindest teilweise das Substrat und das auf dem Substrat aufgebrachte sensitive Element. Beispielsweise können die Kappe und das mit der Kappe verbundene Substrat das sensitive Element und das Substrat umhüllen. Die Kappe weist vorzugsweise Silizium, ein Keramikmaterial oder ein Kunststoffmaterial auf oder besteht aus einem dieser Materialien. Gemäß einer bevorzugten Weiterbildung ist der Träger als FR4-Leiterplatte und die Kappe in Kunststoff ausgeführt.

Gemäß einer Weiterbildung ist die erste Öffnung im Träger ausgebildet. Der Träger kann beispielsweise eine Bohrung aufweisen, die die erste Öffnung der ersten Kammer bildet und dem ersten Medium Zugang zur Oberseite der Membran bietet.

Gemäß einer Weiterbildung ist die zweite Lotverbindung wird die erste Kammer mittels der zweiten Lotverbindung hermetisch abgedichtet, wobei beispielsweise die erste Öffnung die einzige Öffnung der ersten Kammer bildet.

Gemäß einer Weiterbildung wird das sensitive Element nicht mittels der zweiten Lotverbindung elektrisch kontaktiert. Beispielsweise wird das sensitive Element nur durch die erste Lotverbindung elektrisch kontaktiert, wobei die zweite Lotverbindung zum Beispiel der Medienführung und/oder der Abdichtung der ersten Kammer dienen kann.

Gemäß einer Weiterbildung ist die zweite Lotverbindung als geschlossene Kurve ausgeführt. Beispielsweise kann die zweite Lotverbindung eine Ringform oder eine von einer Ringform verschiedene geschlossene Kurvenform aufweisen.

Gemäß einer Weiterbildung ist die zweite Lotverbindung ringförmig ausgeführt. Vorzugsweise wird die erste Kammer mittels der zweiten, ringförmigen Lotverbindung hermetisch abgedichtet, so dass die erste Öffnung die einzige Öffnung der ersten Kammer bildet.

Gemäß einer Weiterbildung ist zwischen dem sensitiven Element und der ersten Lotverbindung sowie zwischen dem sensitiven Element und der zweiten Lotverbindung jeweils ein Elastomerkörper angeordnet. Die Elastomerkörper können beispielsweise mittels Inkjet-Technologie, mittels Siebdruck oder als laminierte Folie, beispielsweise mittels Strukturierung durch Lithografie oder Laserablation, aufgebracht sein. Durch die zwischen den Lotverbindungen und dem sensitiven Element angeordneten Elastomerkörper kann eine mechanische Entkopplung zwischen dem Träger und dem sensitiven Element gewährleistet werden und so sichergestellt werden, dass Störeinflüsse, beispielsweise solche die durch das Packaging verursacht werden, minimiert werden.

Gemäß einer Weiterbildung ist zwischen den Elastomerkörpern und der ersten Lotverbindung eine Metallisierung angeordnet. Vorzugsweise ist die Metallisierung mäander- oder spiralförmig ausgebildet. Dadurch kann vorteilhafterweise eine bei mechanisch und/oder thermomechanisch induzierten Spannungen erforderliche Flexibilität erzielt werden. Vorzugsweise ist die Metallisierung lötbar. Beispielsweise kann die Metallisierung durch Sputtern eines Seedlayers und eine nachfolgende galvanische Abscheidung auf dem Elastomer erzeugt sein.

Gemäß einer Weiterbildung ist die erste Kammer zumindest teilweise mit einer Schutzschicht versehen. Dadurch kann vorteilhafterweise gewährleistet werden, dass als erstes und/oder zweites Medium auch feuchte und/oder korrosive Medien zum Einsatz kommen können.

Gemäß einer Weiterbildung weist die Schutzschicht Parylene auf. Vorteilhafterweise sind alle dem ersten und/oder zweiten Medium ausgesetzten Bereiche oder Teile des mikromechanischen Messelements mit Parylene beschichtet.

Gemäß einer Weiterbildung ist das sensitive Element auf einer dem Träger abgewandten Seite unmittelbar mit einem Substrat verbunden. Vorzugsweise ist eine zweite Kammer zumindest teilweise durch das sensitive Element und das Substrat gebildet. Die zweite Kammer weist vorzugsweise eine zweite Öffnung auf, die durch den Träger und das sensitive Element verläuft. Beispielsweise kann die zweite Kammer durch das sensitive Element, das Substrat, den Träger sowie eine weitere zweite Lotverbindung gebildet sein. Die weitere zweite Lotverbindung kann zum Beispiel als geschlossene Kurve, beispielsweise ringförmig, ausgeführt sein und kann beispielsweise die zweite Kammer abdichten, wobei die zweite Öffnung die einzige Öffnung der zweiten Kammer bildet.

Gemäß einer Weiterbildung ist die Unterseite der Membran einem zweiten Medium mittels der zweiten Öffnung zugänglich. Dadurch kann erreicht werden, dass ein Referenzdruck mittels des zweiten Mediums auf die Membran übertragen werden kann.

Gemäß einer Weiterbildung ist das mikromechanische Messelement als Drucksensor ausgeführt. Der Drucksensor kann beispielsweise als Absolutdrucksensor, als Relativ- oder als Differenzdrucksensor ausgeführt sein.

Gemäß einer Weiterbildung ist das mikromechanische Messelement als Gassensor ausgeführt. Vorteilhafterweise eignet sich der Gassensor zur Detektion gasförmiger Substanzen, wobei eine chemische Information in der Umgebungsluft vom Gassensor in ein elektrisch nutzbares Signal umgewandelt wird.

Gemäß einer Weiterbildung ist das mikromechanische Messelement als Beschleunigungssensor ausgeführt. Der Beschleunigungssensor kann beispielsweise als miniaturisierter Sensor, beispielsweise als piezoelektrischer Sensor oder als sogenanntes MEMS (Micro-Electro-Mechanical System) ausgeführt sein.

Weiterhin wird ein Verfahren zur Herstellung eines mikromechanischen Messelements angegeben. Das dadurch herstellbare oder hergestellte mikromechanische Messelement kann eines oder mehrere Merkmale der vorgenannten Ausführungsformen aufweisen. Die vorher und im Folgenden beschriebenen Ausführungsformen gelten gleichermaßen für das mikromechanische Messelement wie auch für das Verfahren zur Herstellung des mikromechanischen Messelements.

Gemäß einer Ausführungsform wird ein sensitives Element bereitgestellt. Weiterhin wird ein Träger bereitgestellt, der zumindest eine erste Öffnung aufweist. Vorzugsweise weist der Träger zumindest eine Durchkontaktierung, die der Kontaktierung des sensitiven Elements dient, auf. Anschließend wird das sensitive Element mit dem Träger verbunden. Vorzugsweise wird das sensitive Element mit dem Träger mittels einer oder mehreren Lotverbindungen verbunden, wobei zumindest eine der Lotverbindungen das sensitive Element mit der Durchkontaktierung elektrisch leitend verbindet. Die eine oder mehrere Lotverbindungen können beispielsweise mittels einer Lotpaste aufgedruckt werden. Alternativ können die eine oder mehrere Lotverbindungen auch mittels Sputtern oder galvanischer Abscheidung aufgebracht sein. Durch das Verbinden des sensitiven Elements mit dem Träger wird eine elektrische Kontaktierung des sensitiven Elements sowie eine Medienzuführung zum sensitiven Element in einem Prozessschritt realisiert.

Gemäß einer Weiterbildung erfolgt das Verbinden des sensitiven Elements mit dem Träger mittels Flip-Chip-Lötung.

Die Fertigungsprozesse finden sowohl auf Waferebene als auch in den anschließenden Packaging-Prozessschritten als Batch-Prozesse im Nutzen statt und sind so vorteilhafterweise kostengünstig realisierbar. Weiterhin bietet die Fertigungstechnologie großes Potential hinsichtlich der Miniaturisierung des gesamten Gehäuses und ist als Basistechnologie für ein breites Produktspektrum einsetzbar.

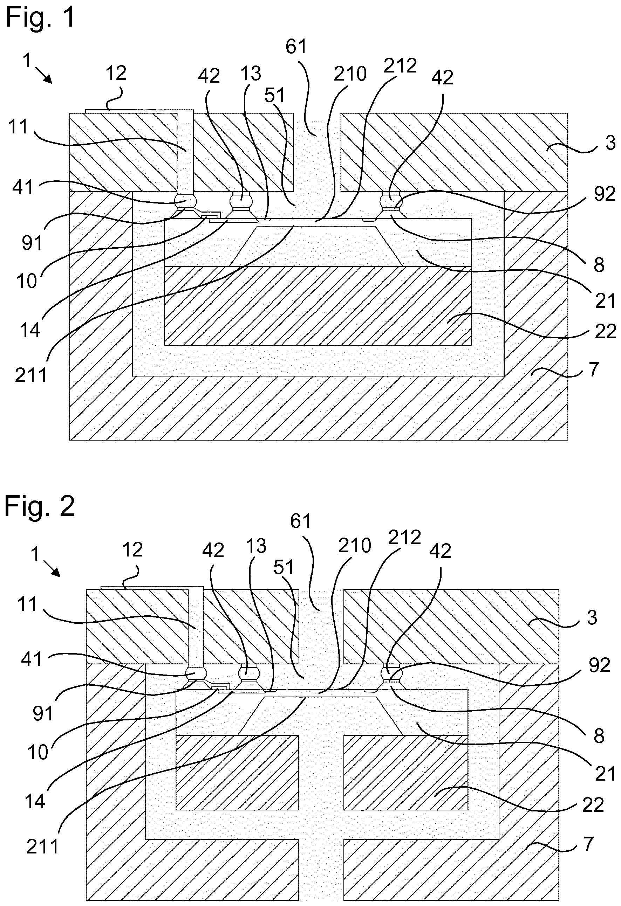

Nachfolgend sind Ausführungsbeispiele von mikromechanischen Messelementen und von Verfahren zu Herstellung eines mikromechanischen Messelements unter Bezugnahme auf die Figuren 1 bis 4 erläutert.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen. Vielmehr können einzelne Elemente wie zum Beispiel Schichten, Bauteile und Bereiche zur besseren Darstellbarkeit und/oder zum besseren Verständnis übertrieben dick oder groß dimensioniert dargestellt sein.

Es zeigen:
Figur 1 eine schematische Schnittansicht eines mikromechanischen Messelements gemäß einem ersten Ausführungsbeispiel,
Figur 2 eine schematische Schnittansicht eines mikromechanischen Messelements gemäß einem weiteren Ausführungsbeispiel,
Figur 3 eine schematische Schnittansicht eines mikromechanischen Messelements gemäß einem weiteren Ausführungsbeispiel und
Figur 4 eine schematische Darstellung eines Verfahrens zur Herstellung eines mikromechanischen Messelements gemäß einem weiteren Ausführungsbeispiel.

Figur 1 zeigt ein mikromechanisches Messelement 1 in einer schematischen Schnittdarstellung. Das mikromechanische Messelement 1 ist als Absolutdrucksensor mit vorderseitiger Medienzuführung ausgeführt.

Das mikromechanische Messelement 1 weist ein sensitives Element 21 und einen Träger 3 auf. Der Träger 3 ist im gezeigten Ausführungsbeispiel eine Keramikplatte. Alternativ kann der Träger 3 auch als FR4-Leiterplatte ausgeführt sein. Das sensitive Element 21 ist als piezoresistiver MEMS Drucksensorchip ausgeführt und weist eine Membran 210 mit einer Unterseite 211 und einer Oberseite 212 auf.

Weiterhin ist das sensitive Element 21 unmittelbar mit einem Substrat 22 aus Glas verbunden. Alternativ kann das Substrat 22 auch Silizium aufweisen oder aus Silizium bestehen. Das sensitive Element 21 ist auf einer dem Substrat 22 abgewandten Seite mittels einer ersten Lotverbindung 41 und einer zweiten Lotverbindung 42 mit dem Träger 3 verbunden. Ein auf dem Träger 3 aufgebrachter Außenkontakt 12, der der externen elektrischen Kontaktierung des Messelements 1 dient, ist mittels einer Durchkontaktierung 11 mit der ersten Lotverbindung 41 elektrisch leitend verbunden. Somit dient die erste Lotverbindung 41 der elektrischen Kontaktierung des sensitiven Element 21. Alternativ kann das mikromechanische Messelement 1 auch eine oder mehrere weitere erste Lotverbindungen 41 aufweisen, die das sensitive Element 21 mit weiteren Durchkontaktierungen 11 im Träger 11 elektrisch leitend verbinden.

Das sensitives Element, der Träger und die zweite Lotverbindung 42, welche als geschlossene Kurve ausgeführt ist, bilden eine erste Kammer 51. Insbesondere ist die zweite Lotverbindung 42 ringförmig ausgeführt. Die erste Kammer 51 weist eine erste Öffnung 61 auf, die im Träger 3 ausgebildet ist und der Zuführung eines ersten Mediums dient. Die erste Kammer 51 ist mittels der zweiten Lotverbindung 42 druckdicht abgedichtet.

Zwischen den Lotverbindungen 41, 42 und dem sensitiven Element ist jeweils ein Elastomerkörper 8 angeordnet, der der mechanischen Entkopplung zwischen dem Träger und dem sensitiven Element dient. Weiterhin ist zwischen der zweiten, ringförmigen Lotverbindung 42 und dem Elastomerkörper sowie zwischen der zweiten Lotverbindung 42 und dem Träger 3 jeweils eine Metallisierung 92 angeordnet. Zwischen der ersten Lotverbindung 41 und dem Elastomerkörper 8 ist ebenfalls eine Metallisierung 91 angeordnet, die mäanderförmig ausgebildet ist. Alternativ kann die Metallisierung 91 auch spiralförmig ausgeführt sein. Durch die mäander- beziehungsweise spiralförmig ausgeführte Metallisierung 91 kann vorteilhafterweise eine Einwirkung mechanischer Spannungen kompensiert werden.

Ein zu messender Druck wird mittels des ersten Mediums auf die Membran 210 übertragen, wobei eine daraus resultierende Deformation der Membran 210 durch implantierte Widerstandsstrukturen 13, die als Piezowiderstände ausgeführt sind, erfasst wird. Ein resultierendes elektrisches Signal wird über hochdotierte Zuleitungen 14, ein Aluminium-Kontaktpad 10, die auf dem Elastomerkörper 8 abgeschiedene Metallisierung 91, die erste Lotverbindung 41 und die Durchkontaktierung 11 zum Außenkontakt 12 geführt. Die Widerstandsstrukturen 13 und Zuleitungen 14 bilden eine piezoresistive Messbrücke zur Druckmessung. Weiterhin ist es möglich, dass die Messbrücke durch weitere funktionale Schichten gebildet wird.

Die erste Kammer 51 ist zumindest teilweise mit einer Schutzschicht aus Parylene versehen. Durch die Beschichtung mit der Schutzschicht kann eine hohe Korrosionsbeständigkeit gegen eine Vielzahl von Medien gewährleistet werden. Beispielsweise können dadurch auch feuchte und korrosive Medien zum Einsatz kommen.

Weiterhin weist das mikromechanische Messelement 1 eine Kappe 7 aus Silizium auf, die unmittelbar mit dem Träger 3 verbunden ist. Alternativ kann die Kappe auch ein Kunststoffmaterial oder ein Keramikmaterial aufweisen. Weiterhin ist es möglich, dass das mikromechanische Messelement 1 ohne Kappe 7 ausgeführt ist.

Figur 2 zeigt ein mikromechanisches Messelement 1 in einer Schnittansicht gemäß einem weiteren Ausführungsbeispiel.

Im Unterschied zum Ausführungsbeispiel gemäß Figur 1 weisen die Kappe 7 und das Substrat 22 auf einer der Unterseite 211 der Membran 210 zugewandten Seite jeweils eine Öffnung auf. Über die Öffnungen in der Kappe 7 und um Substrat 22 kann der Unterseite 211 der Membran 210 ein zweites Medium zugeführt werden. Somit weist das in Figur 2 gezeigte mikromechanische Messelement 1 Medienzuführungen an Vorder- und Rückseite auf und kann dadurch als Relativ- oder Differenzdrucksensor genutzt werden. Auf die Kappe 7 kann verzichtet werden, wenn der Relativdruck dem Umgebungsdruck entspricht.

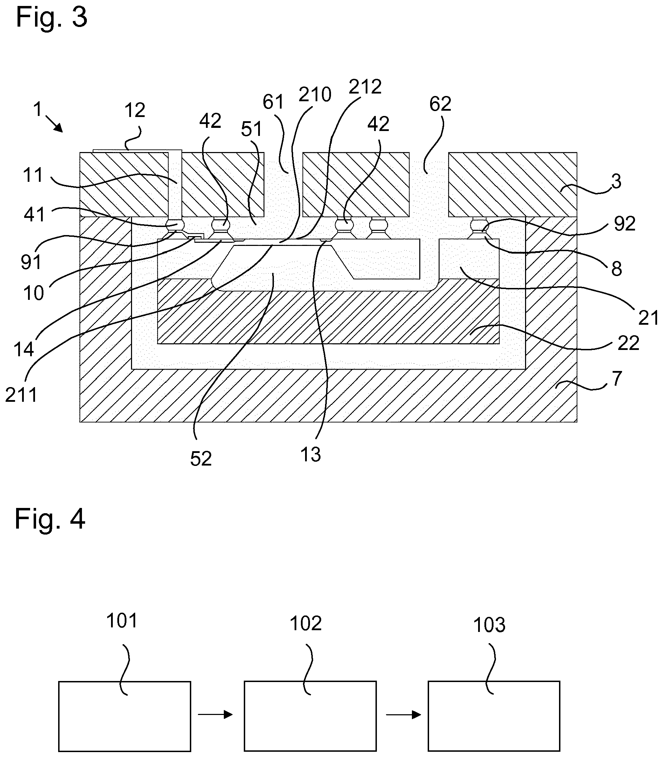

In Figur 3 ist ein mikromechanisches Messelement 1 in einer Schnittansicht gemäß einem weiteren Ausführungsbeispiel dargestellt. Das mikromechanische Messelement 1 ist als Relativ- oder Differenzdrucksensor mit einseitiger, vorderseitiger Medienzuführung ausgeführt.

Im Unterschied zum Ausführungsbeispiel gemäß Figur 1 weist der Träger 3 eine zweite Öffnung 62 auf, die der Zuführung eines zweiten Mediums dient. Die zweite Öffnung 62 erstreckt sich durch den Träger 3 und durch eine Aussparung im sensitiven Element 21, die beispielsweise mittels Laserbohren, DRIE- oder KOH-Ätzen erzeugt sein kann. Das sensitive Element 21 und das Substrat 22 bilden dadurch eine zweite Kammer 52 aus, wobei über die zweite Öffnung 62 ein zweites Medium der Unterseite 211 der Membran 210 zugänglich ist. Somit wird in dem in Figur 3 gezeigten Ausführungsbeispiel das erste Medium der Oberseite 212 der Membran 210 zugeführt, während ein Referenzdruck auf Chipebene mittels des zweiten Mediums auf die Unterseite 211 der Membran 210 geleitet wird.

In Figur 4 ist eine schematische Darstellung eines Verfahrens zur Herstellung eines mikromechanischen Messelements 1 gemäß einem der Ausführungsbeispiele der Figuren 1 bis 3 gezeigt. Die folgenden Verweise auf Merkmale des mikromechanischen Messelements beziehen sich daher rein beispielhaft auf die Elemente der Figuren 1 bis 3 unter Verwendung der dort gezeigten Bezugszeichen.

In einem ersten Verfahrensschritt 101 wird ein sensitives Element 21 bereitgestellt. Das sensitive Element kann beispielsweise auf einem Substrat 22 aufgebracht sein. In einem zweiten Verfahrensschritt 102 wird ein Träger 3, der zumindest eine erste Öffnung 61 und zumindest eine Durchkontaktierung 11 aufweist, bereitgestellt. In einem dritten Verfahrensschritt 102 wird das sensitive Element 21 mit dem Träger 3 mittels Lotverbindungen 41, 42 verbunden. Das Verbinden des sensitiven Elements 21 mit dem Träger 3 wird dabei in einem einzigen Prozessschritt realisiert, bei dem gleichzeitig eine elektrische Kontaktierung des sensitiven Elements 21 sowie eine Medienzuführung zum sensitiven Element 21 realisiert werden. Dadurch erfolgt vorteilhafterweise eine vorderseitige Kontaktierung sowohl der elektrischen als auch der fluidischen Zuführungen in einem simultanen Prozessschritt.

### Bezugszeichenliste

- 1: Messelement
- 21: sensitives Element
- 210: Membran
- 211: Unterseite der Membran
- 212: Oberseite der Membran
- 22: Substrat
- 3: Träger
- 41: erste Lotverbindung
- 42: zweite Lotverbindung
- 51: erste Kammer
- 52: zweite Kammer
- 61: erste Öffnung
- 62: zweite Öffnung
- 7: Kappe
- 8: Elastomerkörper
- 91, 92: Metallisierung
- 10: Kontaktpad
- 11: Durchkontaktierung
- 12: Außenkontakt
- 13: Widerstandsstruktur
- 14: Zuleitung
- 101, 102, 103: Verfahrensschritt

## Patentansprüche

1. Mikromechanisches Messelement (1), aufweisend ein sensitives Element (21) und einen Träger (3),
- wobei das sensitive Element (21) mittels zumindest einer ersten und zumindest einer zweiten Lotverbindung (41, 42) mit dem Träger (3) verbunden ist,
- wobei das sensitive Element (21) über die erste Lotverbindung (41) elektrisch kontaktiert wird, und
- wobei das sensitive Element (21), der Träger (3) und die zweite Lotverbindung (42) eine erste Kammer (51) ausbilden, wobei die erste Kammer (51) eine erste Öffnung (61) aufweist, **dadurch gekennzeichnet dass**, zwischen dem sensitiven Element (21) und den Lotverbindungen (41, 42) jeweils ein Elastomerkörper (8) angeordnet ist und wobei zwischen den Elastomerkörpern (8) und der ersten Lotverbindung (41) eine Metallisierung (91) angeordnet ist.

2. Mikromechanisches Messelement nach Anspruch 1,
- wobei das sensitive Element (21) eine Membran (210) mit einer Unterseite (211) und einer Oberseite (212) aufweist, und
- wobei die Oberseite (212) der Membran (210) einem ersten Medium mittels der ersten Öffnung (61) zugänglich ist.

3. Mikromechanisches Messelement nach einem der vorhergehenden Ansprüche, wobei die erste Öffnung (61) im Träger (3) ausgebildet ist.

4. Mikromechanisches Messelement nach einem der vorhergehenden Ansprüche, wobei die zweite Lotverbindung (42) ringförmig ausgebildet ist.

5. Mikromechanisches Messelement nach einem der vorherigen Ansprüche, wobei zwischen den Elastomerkörpern (8) und der ersten Lotverbindung (41) eine Metallisierung (91) angeordnet ist, die mäander- oder spiralförmig ausgebildet ist.

6. Mikromechanisches Messelement nach einem der vorhergehenden Ansprüche, wobei die erste Kammer (51) zumindest teilweise mit einer Schutzschicht versehen ist.

7. Mikromechanisches Messelement nach Anspruch 6, wobei die Schutzschicht Parylene aufweist.

8. Mikromechanisches Messelement nach einem der vorhergehenden Ansprüche,
- wobei das sensitive Element (21) auf einer dem Träger (3) abgewandten Seite unmittelbar mit einem Substrat (22) verbunden ist,
- wobei eine zweite Kammer (52) zumindest teilweise durch das sensitive Element (21) und das Substrat (22) gebildet ist, und
- wobei die zweite Kammer (52) eine zweite Öffnung (62) aufweist, die durch den Träger (3) und das sensitive Element (21) verläuft.

9. Mikromechanisches Messelement nach Anspruch 8, wobei die Unterseite (211) der Membran (210) einem zweiten Medium mittels der zweiten Öffnung (62) zugänglich ist.

10. Mikromechanisches Messelement nach einem der vorhergehenden Ansprüche, wobei das Messelement (1) als Drucksensor ausgeführt ist.

11. Mikromechanisches Messelement nach einem der vorhergehenden Ansprüche, wobei das Messelement (1) als Gassensor ausgeführt ist.

12. Mikromechanisches Messelement nach einem der vorhergehenden Ansprüche, wobei das Messelement (1) als Beschleunigungssensor ausgeführt ist.

13. Verfahren zur Herstellung eines mikromechanischen Messelements (1) mit den folgenden Schritten:
- Bereitstellen eines sensitiven Elements (21),
- Bereitstellen eines Trägers (3), der zumindest eine erste Öffnung (61) zur Zuführung eines Mediums sowie zumindest eine Durchkontaktierung (11) zur elektrischen Kontaktierung des sensitiven Elements (21) aufweist,
- Verbinden des sensitiven Elements (21) mit dem Träger (3), wobei durch das Verbinden des sensitiven Elements (21) mit dem Träger (3) die elektrische Kontaktierung des sensitiven Elements (21) sowie die Medienzuführung zum sensitiven Element (21) in einem Prozessschritt hergestellt werden, wobei das sensitive Element (21) mittels zumindest einer ersten und zumindest einer zweiten Lotverbindung (41, 42) mit dem Träger (3) verbunden wird,
wobei das sensitive Element (21) über die erste Lotverbindung (41) elektrisch kontaktiert wird, und
wobei zwischen dem sensitiven Element (21) und den Lotverbindungen (41, 42) jeweils ein Elastomerkörper (8) angeordnet wird und wobei zwischen den Elastomerkörpern (8) und der ersten Lotverbindung (41) eine Metallisierung (91) angeordnet wird.

14. Verfahren nach Anspruch 13, wobei das Verbinden des sensitiven Elements (21) mit dem Träger (3) mittels Flip-Chip-Lötung erfolgt.

## Claims

1. Micromechanical measuring element (1), having a sensitive element (21) and a carrier (3),
- wherein the sensitive element (21) is connected to the carrier (3) by means of at least one first and at least one second solder connection (41, 42),
- wherein the sensitive element (21) is contacted electrically by means of the first solder connection (41), and
- wherein the sensitive element (21), the carrier (3) and the second solder connection (42) form a first chamber (51), wherein the first chamber (51) has a first opening (61), **characterized in that** an elastomer body (8) is arranged in each case between the sensitive element (21) and the solder connections (41, 42) and wherein a metallization (91) is arranged between the elastomer bodies (8) and the first solder connection (41).

2. Micromechanical measuring element according to Claim 1,
- wherein the sensitive element (21) has a membrane (210) with a bottom side (211) and a top side (212), and
- wherein the top side (212) of the membrane (210) is accessible to a first medium by means of the first opening (61) .

3. Micromechanical measuring element according to one of the preceding claims, wherein the first opening (61) is realized in the carrier (3).

4. Micromechanical measuring element according to one of the preceding claims, wherein the second solder connection (42) is realized so as to be ring-shaped.

5. Micromechanical measuring element according to one of the preceding claims, wherein a metallization (91), which is realized in a meandering or helical manner, is arranged between the elastomer bodies (8) and the first solder connection (41).

6. Micromechanical measuring element according to one of the preceding claims, wherein the first chamber (51) is provided at least in part with a protective layer.

7. Micromechanical measuring element according to Claim 6, wherein the protective layer comprises parylene.

8. Micromechanical measuring element according to one of the preceding claims,
- wherein the sensitive element (21) is connected directly to a substrate (22) on a side which is remote from the carrier (3),
- wherein a second chamber (52) is formed at least in part by the sensitive element (21) and the substrate (22), and
- wherein the second chamber (52) has a second opening (62) which runs through the carrier (3) and the sensitive element (21).

9. Micromechanical measuring element according to Claim 8, wherein the bottom side (211) of the membrane (210) is accessible to a second medium by means of the second opening (62).

10. Micromechanical measuring element according to one of the preceding claims, wherein the measuring element (1) is realized as a pressure sensor.

11. Micromechanical measuring element according to one of the preceding claims, wherein the measuring element (1) is realized as a gas sensor.

12. Micromechanical measuring element according to one of the preceding claims, wherein the measuring element (1) is realized as an acceleration sensor.

13. Method for producing a micromechanical measuring element (1), said method having the following steps:
- providing a sensitive element (21),
- providing a carrier (3) which has at least one first opening (61) for supplying a medium and at least one feedthrough (11) for contacting the sensitive element (21) electrically,
- connecting the sensitive element (21) to the carrier (3), wherein the sensitive element (21) is contacted electrically and media is supplied to the sensitive element (21) in one process step by connecting the sensitive element (21) to the carrier (3),
wherein the sensitive element (21) is connected to the carrier (3) by means of at least one first and at least one second solder connection (41, 42),
wherein the sensitive element (21) is contacted electrically by means of the first solder connection (41), and
wherein an elastomer body (8) is arranged in each case between the sensitive element (21) and the solder connections (41, 42) and wherein a metallization (91) is arranged between the elastomer bodies (8) and the first solder connection (41).

14. Method according to Claim 13, wherein the sensitive element (21) is connected to the carrier (3) by means of flip-chip soldering.

## Revendications

1. Elément micromécanique de mesure (1) présentant un élément sensible (21) et un support (3),
l'élément sensible (21) étant relié au support (3) au moyen d'au moins une première et d'au moins une deuxième liaison brasée (41, 42),
l'élément sensible (21) étant mis en contact électrique par la première liaison brasée (41) et
l'élément sensible (21), le support (3) et la deuxième liaison brasée (42) formant une première chambre (51), la première chambre (51) présentant une première ouverture (61),
**caractérisé en ce que**
un corps (8) en élastomère est disposé entre l'élément sensible (21) et chacune des liaisons brasées (41, 42) et
**en ce qu'**une métallisation (91) est disposée entre le corps (8) en élastomère et la première liaison brasée (41).

2. Elément micromécanique de mesure selon la revendication 1, dans lequel l'élément sensible (21) présente une membrane (210) dotée d'une face inférieure (211) et d'une face supérieure (212), la face supérieure (212) de la membrane (210) donnant accès à un premier fluide au moyen de la première ouverture (61) .

3. Elément micromécanique de mesure selon l'une des revendications précédentes, dans lequel la première ouverture (61) est formée dans le support (3).

4. Elément micromécanique de mesure selon l'une des revendications précédentes, dans lequel la deuxième liaison brasée (42) a une forme annulaire.

5. Elément micromécanique de mesure dans lequel la métallisation (91) configurée en méandres ou en spirale est disposée entre le corps (8) en élastomère et la première liaison brasée (41).

6. Elément micromécanique de mesure dans lequel au moins une partie de la première chambre (51) est dotée d'une couche de protection.

7. Elément micromécanique de mesure selon la revendication 6, dans lequel la couche de protection présente du parylène.

8. Elément micromécanique de mesure selon l'une des revendications précédentes, dans lequel l'élément sensible (21) est relié directement à un substrat (22) sur un côté non tourné vers le support (3),
une deuxième chambre (52) est formée au moins en partie par l'élément sensible (21) et le substrat (22) et
la deuxième chambre (52) présente une deuxième ouverture (62) qui traverse le support (3) et l'élément sensible (21).

9. Elément micromécanique de mesure selon la revendication 8, dans lequel la face inférieure (211) de la membrane (210) donne accès à un deuxième fluide au moyen de la deuxième ouverture (62).

10. Elément micromécanique de mesure selon l'une des revendications précédentes, dans lequel l'élément de mesure (1) est configuré comme capteur de pression.

11. Elément micromécanique de mesure selon l'une des revendications précédentes, dans lequel l'élément de mesure (1) est configuré comme capteur de gaz.

12. Elément micromécanique de mesure selon l'une des revendications précédentes, dans lequel l'élément de mesure (1) est configuré comme capteur d'accélération.

13. Procédé de fabrication d'un élément micromécanique de mesure (1), le procédé présentant les étapes suivantes :
préparer un élément sensible (21),
préparer un support (3) qui présente au moins une première ouverture (61) permettant d'amener un fluide ainsi qu'au moins une traversée au contact (11) qui assure le contact électrique avec l'élément sensible (21),
relier l'élément sensible (21) au support (3), la liaison de l'élément sensible (21) avec le support (3) permettant d'établir le contact électrique entre l'élément sensible (21) et l'apport de fluide à l'élément sensible (21) en une seule étape de traitement, l'élément sensible (21) étant relié au support (3) au moyen d'au moins une première et d'au moins une deuxième liaison brasée (41, 42),
l'élément sensible (21) étant mis en contact électrique par l'intermédiaire de la première liaison brasée (41),
un corps (8) en élastomère étant disposé entre l'élément sensible (21) et chacune des liaisons brasées (41, 42) et
une métallisation (91) étant disposée entre le corps (8) en élastomère et la première liaison brasée (41) .

14. Procédé selon la revendication 13, dans lequel la liaison de l'élément sensible (21) avec le support (3) s'effectue par brasage dit "flip-chip".
